# FASCICULE DE BREVET EUROPEEN

(11) **EP 2 047 534 B1**
(45) Date de publication et mention de la délivrance du brevet: **16.03.2011**
(21) Numéro de dépôt: 07787846.0
(22) Date de dépôt: 24.07.2007
(51) Int. Cl.: H01L 51/50, H01L 51/54, C07F 9/6568

(54) **DIODES ORGANIQUES ÉLECTROLUMINESCENTES BLANCHES À BASE DE MOLÉCULES DÉRIVÉES DU PHOSPHOLE.**
WEISSELEKTROLUMINESZENTE ORGANISCHE DIODEN AUF DER BASIS VON AUS PHOSPHOL ABGELEITETEN MOLEKÜLEN
WHITE ELECTROLUMINESCENT ORGANIC DIODES BASED ON MOLECULES DERIVED FROM PHOSPHOLE.

(30) Priorité: 27.07.2006 FR 0653146
(43) Date de publication de la demande: 15.04.2009
(73) Titulaire: Commissariat à l'Énergie Atomique et aux Énergies Alternatives, 75015 Paris (FR); Universite Rennes 1, 35000 Rennes (FR)
(72) Inventeur: LEMAITRE, Noella, 73000 Chambéry (FR); GEFFROY, Bernard, 94240 L'hay Les Roses (FR); FADHEL, Omrane, 22100 Saint Carne (FR); HISSLER, Muriel, 35135 Chantepie (FR); REAU, Régis, 35520 Chapelle Des Fougerez (FR)
(74) Mandataire: Poulin, Gérard
(86) Numéro de dépôt international: PCT/EP2007/057604
(87) Numéro de publication internationale: WO 2008/012298

(56) Documents cités:
- FR-A1- 2 873 586
- US-A1- 2003 099 860
- US-A1- 2004 046 495
- HISSLER M ET AL: "Organophosphorus pi-conjugated materials: the rise of a new field" JOURNAL OF ORGANOMETALLIC CHEMISTRY, ELSEVIER-SEQUOIA S.A. LAUSANNE, CH, vol. 690, no. 10, 16 mai 2005 (2005-05-16), pages 2482-2487, XP004877382 ISSN: 0022-328X
- SU HAI-CHING ; FADHEL OMRANE ; YANG CHIH-JEN ; CHO TING-YI ; FAVE CLAIRE ; HISSLER MURIEL ; WU CHUNG-CHIH ; REAU REGIS: "Toward functional pi -conjugated organophosphorus materials: Design of phosphole-based oligomers for electroluminescent devices" JOURNAL OF THE AMERICAN CHEMICAL SOCIETY, vol. 128, 25 janvier 2006 (2006-01-25), pages 983-995, XP002423193 cité dans la demande
- FAVE, C., CHO T.-Y.; HISSLER M.; CHEN C.-W., LUH T.-Y.; WU C.-C.; REAU R.: "First Examples of organophosphorous-Containing Materials for light-Emitting Diodes" JOURNAL OF THE AMERICAN CHEMICALSOCIETY, vol. 125, 2003, pages 9254-9255, XP002423194 cité dans la demande
- D'ANDRADE B. W.; FORREST S. R.: "White organic light-emitting devices for solid-state lighting" ADVANCED MATERIALS, vol. 16, 16 septembre 2004 (2004-09-16), pages 1585-1595, XP002423195
- THOMAS BAUMGARTNER: "$$Öpi$$ -Conjugated Heterocyclic fused Bithiophene Materials" JOURNAL OF INORGANIC AND ORGANOMETALLIC POLYMERS, KLUWER ACADEMIC PUBLISHERS-PLENUM PUBLISHERS, NE, vol. 15, no. 4, 22 avril 2006 (2006-04-22), pages 389-409, XP019400784 ISSN: 1574-1451

## Description

### DOMAINE TECHNIQUE

L'invention se rapporte à des diodes organiques électroluminescentes blanches dont la lumière émise provient d'un mélange de couleurs fournies par au moins deux matériaux luminophores.

### ÉTAT DE LA TECHNIQUE ANTÉRIEURE

L'électroluminescence est un phénomène par lequel une excitation électrique donne lieu à l'émission d'un rayonnement électromagnétique. Une diode électroluminescente organique fonctionne par création d'excitons. Pour créer des excitons, une couche de matériau luminophore est prise en sandwich entre une électrode de cathode et une électrode d'anode. Des électrons sont injectés à partir de la cathode tandis que des trous sont injectés à partir de l'anode. Les électrons et les trous se déplacent dans le matériau luminophore et se rencontrent pour former des excitons qui sont des paires électron-trou excités et liés. Lorsque l'électron et le trou d'un exciton se combinent, un photon peut être émis.

Les diodes organiques électroluminescentes ont connu un intérêt croissant ces dernières années à cause de leur faible tension de fonctionnement, leur forte luminance, leur angle de vue important ainsi qu'à leur capacité à conduire à des dispositifs en couleurs et plats. Grâce à ces propriétés, les premières applications envisagées pour ces diodes, encore appelées OLED (pour « organic light-emitting diode »), ont été des dispositifs d'affichage monochromes puis en couleurs.

Le domaine de l'affichage n'est plus seulement en considération. En effet les OLED blanches ou WOLED (pour « White OLED ») sont de bons candidats pour la prochaine génération de sources lumineuses, en remplacement des lampes à incandescence, grâce à leur fort potentiel d'économie d'énergie, leur grande efficacité et leur possibilité de conduire à des dispositifs fins et flexibles. Les OLED blanches sont donc maintenant envisagées comme source lumineuse de faible coût pour la réalisation d'éclairage arrière de dispositifs LCD, pour l'éclairage domestique, etc. Pour toutes ces applications, les OLED blanches employées doivent posséder une grande efficacité et une grande luminosité, ainsi que des coordonnées chromatiques proches de celles du D65, illuminant standard de la Commission Internationale de l'Eclairage (voir le document [1] cité à la fin de la description), qui sont (0,313-0,329) sous lumière du jour.

La largeur du spectre d'émission des chromophores classiquement utilisés dans les OLED représentant environ un tiers du spectre visible, une émission blanche efficace et très difficilement obtenue à partir d'une molécule unique. Cependant, une lumière blanche composite peut être obtenue en mélangeant les trois couleurs primaires (bleu, vert et rouge) ou deux couleurs complémentaires dans les bonnes proportions au sein d'une même diode. On peut se référer à ce sujet aux documents [2] et [3].

L'obtention de lumière blanche par émission des trois couleurs bleu (B), Vert (V) et rouge (R) a été décrite dans l'art antérieur. Ainsi, le document US 2003/099860 divulgue la combinaison d'une émission bleue provenant du 4,4'-bis (2,2-diphénylvinyl) biphényle ou DPVBi avec des émissions rouges et vertes provenant respectivement du [2-méthyl-6-[2-(2,3,6,7-tétrahydro -1H, 5H-benzo[ij] quinolizin-9-yl) éthényl]-4H-pyranne-4-ylidène] propane-dinitrite ou DCM2 et de la coumarine 6. Dans ce cas, la diode blanche est constituée des différentes couches émissives R, V, B ainsi que de couches de transport dans une structure multicouche. Une autre approche peut également être employée dans laquelle les émetteurs bleu, vert et rouge sont pixelisés au sein d'un dispositif comme le divulgue le document US 2003/197 665.

L'utilisation de deux chromophores émettant des couleurs complémentaires pour la réalisation de diodes organiques électroluminescentes blanches a déjà été divulguée dans les documents US 2004/0 241 491, US 2004/ 185 300 et EP-A-1 381 096. Ces documents utilisent l'association d'une couche émettrice bleue avec un dérivé de rubrène ou de pérylène comme émetteur jaune orangé de façon à produire de la lumière blanche. Les émetteurs jaunes orangés peuvent être utilisés comme dopant de la couche émettrice bleue ou d'une couche de transport, ainsi qu'en couche émettrice continue.

Par ailleurs, des dérivés de phospholes ont été testés en tant qu'émetteur ou matrice d'un dopant rouge, le 4-(dicyanométhylène)-2-t-butyl-6(1,1,7,7-tétraméthyljulolidyl-9-enyl)-4H-pyranne ou DCJTB, en structure multicouche entre deux électrodes (voir les documents [4] et [5]). Le document JP 2003-231741 A (correspondant au document US 2005/042 195) divulgue la synthèse et la caractérisation de polymères contenant un fragment benzophosphole. Ces polymères sont décrits comme potentiellement intéressants en tant que composés émissifs dans des OLED.

### EXPOSÉ DE L'INVENTION

Il est proposé par la présente invention d'utiliser des matériaux (polymères ou molécules) dérivés du phosphole pour la réalisation de diodes organiques électroluminescentes blanches. L'ingénierie moléculaire pouvant être réalisée sur cette famille de composés permet l'obtention de molécules fluorescentes et phosphorescentes efficaces, ainsi que la modulation de leur longueur d'onde d'émission. Cette modulation permet d'ajuster la couleur d'émission des molécules et ainsi d'obtenir une lumière blanche de bonne qualité.

L'invention a donc pour objet une diode organique électroluminescente blanche telle que décrite dans la revendication 1.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 est une vue schématique et en coupe transversale d'une diode électroluminescente blanche selon l'invention,
- la figure 2 est une représentation des coordonnées chromatiques de diodes utilisant des dérivés du phosphole et montrant l'influence de ces dérivés,
- la figure 3 représente des spectres d'électroluminescence des diodes utilisant des dérivés du phosphole,
- la figure 4 est une représentation des coordonnées chromatiques de diodes utilisant des dérivés du phosphole et montrant l'influence de ces dérivés,
- la figure 5 représente des spectres d'électroluminescence de diodes utilisant des dérivés du phosphole,
- la figure 6 est une représentation des coordonnées chromatiques de diodes utilisant des dérivés du phosphole et montrant l'influence de ces dérivés.

### EXPOSÉ DÉTAILLÉ DE MODES DE RÉALISATION PARTICULIERS

Selon la présente invention, on réalise des diodes organiques électroluminescentes blanches telle que décrite dans la revendication 1.

Les exemples qui suivent illustrent la réalisation de WOLED conformément à l'invention et présentent les caractéristiques de ces dernières.

Toutes les diodes présentées sont obtenues par évaporation thermique sous vide (< 10⁻⁶ Torr) de petites molécules organiques sur des substrats verre - ITO à des vitesses de dépôt de l'ordre de 0,2 à 0,3 nm/s. Les couches dopées sont réalisées par co-évaporation thermique de la matrice et du dopant. Les matériaux organiques utilisés sont commerciaux à l'exception des dérivés de phosphole, matériaux synthétisés dans le cadre de l'invention. Des couches d'injection de trous (CuPc) et de transport de trous (NPB) et d'électrons (Alq₃) sont utilisées pour la réalisation des diodes présentées en exemple.

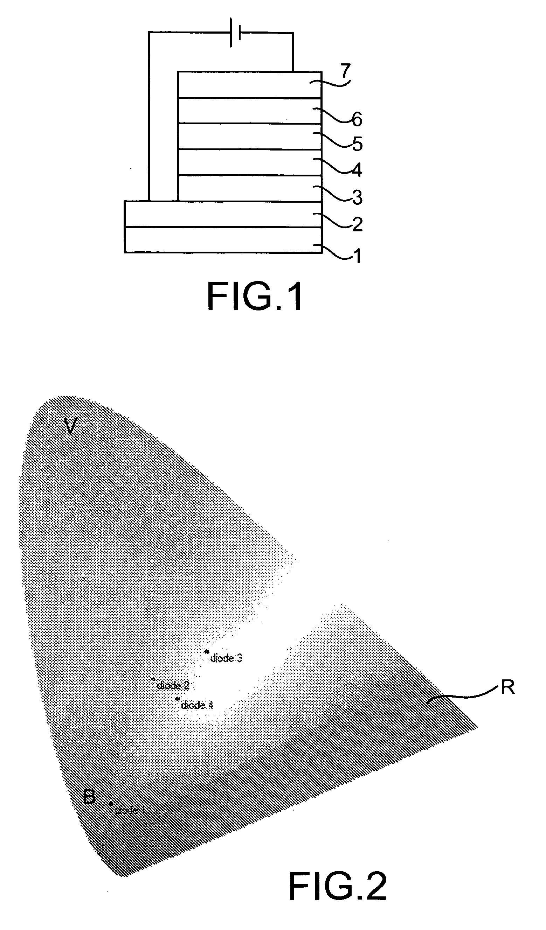

La figure 1 est une vue schématique et en coupe d'une diode électroluminescente blanche selon l'invention. Elle est constituée par un empilement comprenant un substrat transparent en verre 1, une électrode transparente 2 servant d'anode, une couche d'injection de trous 3, une couche de transport de trou 4, une couche émettrice de lumière 5, une couche de transport d'électrons 6 et une électrode 7 servant de cathode. L'électrode transparente 2 est par exemple une couche d'ITO (oxyde mixte d'étain et d'indium) de 100 à 200 nm d'épaisseur. La couche d'injection de trous 3 peut être en phthalocyanine de cuivre (ou CuPc) et avoir 10 nm d'épaisseur. La couche de transport de trous 4 peut être en N,N'-bis-(1-naphthyl)-N,N'-diphényl-1.1' biphényl (ou NPB)-4-4'-diamine et avoir 50 nm d'épaisseur. La couche émettrice de lumière 5 peut être une couche de DPVBi (formant une matrice bleue) dopée par un dérivé du phosphole, selon un exemple non-conforme à l'invention. Son épaisseur peut être de 50 nm. La couche de transport d'électrons 6 peut être une couche de tris (8-hydroxyquinoline) aluminium (ou Alq₃) et avoir 10 nm d'épaisseur. La cathode 7 peut être formée par une couche de 1,2 nm d'épaisseur de fluorure de lithium et une couche de 100 nm d'épaisseur d'aluminium déposées successivement sur la couche 6.

Les caractéristiques courant-tension-luminance (I-V-L) ainsi que les spectres d'électroluminescence des diodes sont enregistrés sous air à température ambiante, sans encapsulation des dispositifs. Les coordonnés chromatiques (x ; y) de la Commission Internationale de l'Eclairage (CIE) des diodes sont données selon la convention de 1931.

### Premier exemple de réalisation non-conforme à l'invention

Les deux molécules fluorescentes suivantes ont été utilisées à différents pourcentages de dopage dans la matrice bleue DPVBi de la diode décrite ci-dessus et représentée à la figure 1.

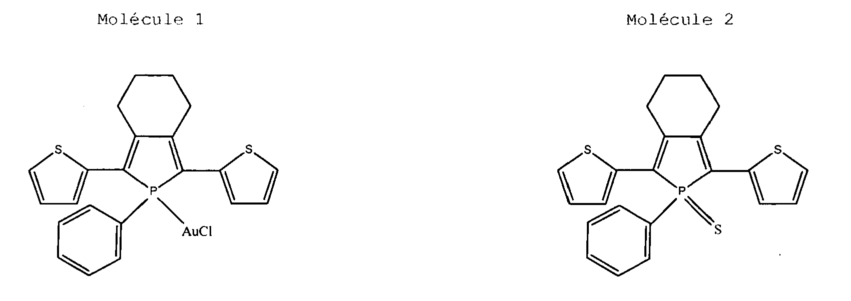

Le tableau 1 regroupe les performances et les coordonnées chromatiques des différentes diodes réalisées. La diode 1 est une diode bleue de référence pour laquelle la matrice DPVBi n'a pas été dopée. Ses coordonnées chromatiques sont (0,155 ; 0,130) et son efficacité quantique est de 3,6%. Le dopage est donné en % en poids du dopant par rapport à la matrice. λₑₘmax est la longueur d'onde du maximum d'émission.

**Tableau 1**

| Diode | λₑₘ max (nm) | Efficacités | | | CIE | | Couleur |
|---|---|---|---|---|---|---|---|
| | | % | cd/A | Im/W | x | y | |
| 1/DPVBi | 452 | 3,6 | 4,0 | 1,2 | 0,155 | 0,130 | bleu |
| 2/DPVBi: molécule 1 (0,4%) | 476/500 | 2,4 | 5,8 | 1,9 | 0,222 | 0,344 | vert-bleu |
| 3/DPVBi: molécule 2 (0,2%) | 444/548 | 2,7 | 7,0 | 2,3 | 0,305 | 0,391 | Blanc-vert |
| 4/DPVBi: molécule 2 (0,1%) | 444/548 | 2,7 | 6,1 | 2,0 | 0,260 | 0,310 | blanc |

La diode 2 réalisée possède des coordonnées chromatiques de (0,222 ; 0,344). La couleur d'émission de cette diode est donc vert-bleu comme le montre la figure 2 qui est une représentation des coordonnées chromatiques des diodes 1 à 4 dans le diagramme CIE de 1931. Dans ce diagramme, les zones rouge (R), verte (V) et bleu (B) ont été indiquées. Le remplacement du substituant AuCl de l'atome de P par un atome de soufre (molécule 2) permet de décaler l'émission du dopant de 500 à 548 nm et ainsi d'obtenir des diodes blanches.

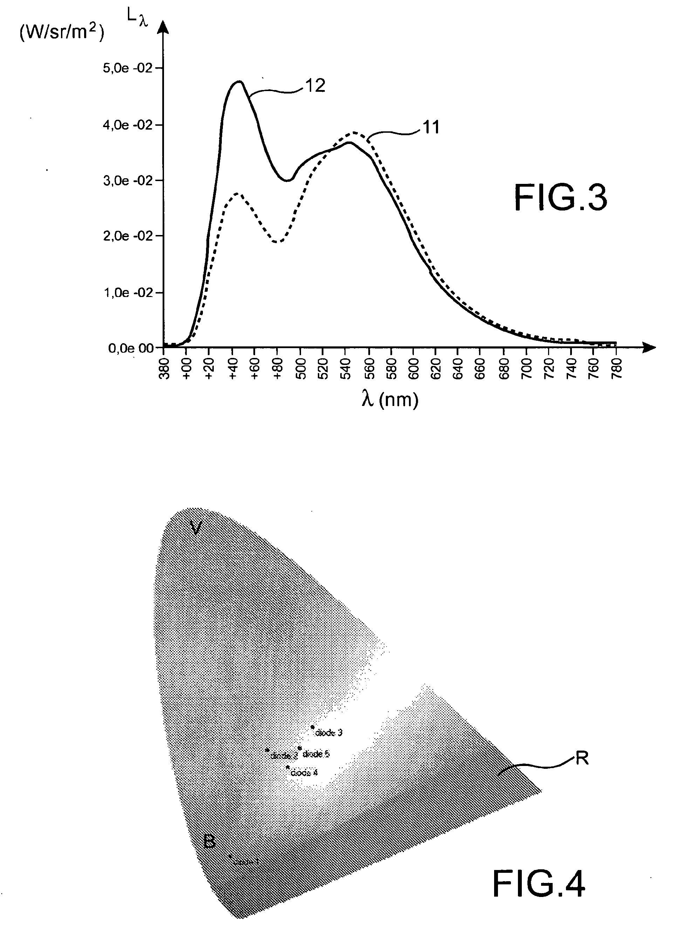

La figure 3 représente les spectres d'électroluminescence des diodes 3 et 4. L'axe des ordonnées représente la luminance spectrale L_{λ} en watts par stéradian et par m². L'axe des abscisses représente la longueur d'onde λ. La courbe 11 a été tracée pour la diode 3 et la courbe 12 a été tracée pour la diode 4.

La modulation des émissions respectives de la matrice et du dopant (voir la figure 3) en jouant sur le pourcentage de dopage permet d'ajuster les coordonnées chromatiques des diodes pour obtenir un blanc de bonne qualité optique. Ainsi, en diminuant le pourcentage de dopage de la diode 3 de 0,2 % à 0,1 % pour obtenir la diode 4, les coordonnées chromatiques des diodes passent de (0, 305 ; 0,391) à (0,260 ; 0,310) soit d'un blanc légèrement vert à un blanc de meilleure qualité optique.

### Deuxième exemple de réalisation non-conforme à l'invention

Les molécules de l'exemple 1 peuvent également être utilisées comme dopant d'une couche de transport de la diode décrite ci-dessus, par exemple la couche de transport de trous. Pour cette diode, la couche de transport de trous est en NPB. Le tableau 2 donne les performances et les coordonnées chromatiques de la diode 5 réalisée en dopant le NPB par la molécule 2 à raison de 0,25% en poids.

**Tableau 2**

| Diode | λₑₘ max (nm) | Efficacités | | | CIE | | Couleur |
|---|---|---|---|---|---|---|---|
| | | % | cd/A | Im/W | x | y | |
| 5/NPB: molécule 2 (0,25%) | 448/548 | 2,8 | 6,8 | 2,3 | 0,281 | 0,348 | blanc |

La figure 4 est une représentation des coordonnées chromatiques des diodes 1 à 5 dans le diagramme CIE de 1931.

Le dopage de la couche de transport à la place de la matrice bleue par la molécule 2 peut également conduire à une diode blanche, comme le prouve la diode 5 dont les coordonnées chromatiques sont (0,281 ; 0,348). L'alignement des coordonnées (x ; y) des diodes 1, 3, 4 et 5 sur une même droite montre que l'émission du dopant est similaire qu'il se trouve dans le NPB ou le DPVBi (voir la figure 4). La couleur de la diode est une couleur composite de deux constituants: le bleu provenant du DPVBi (diode 1) et du jaune orangé provenant du dopant (molécule 2). L'efficacité quantique de la diode 5 est de 2,8 %, rendement similaire à celui des diodes 3 et 4.

Ceci prouve que le dopage peut être réalisé dans la matrice bleue mais également dans la couche de transport.

### Troisième exemple de réalisation

Dans cet exemple de réalisation, le dopant utilisé dans la couche de transport de trous est la molécule 3 qui, par rapport à la molécule 2, possède des groupements méthyles en position 4 sur les cycle thiophènes.

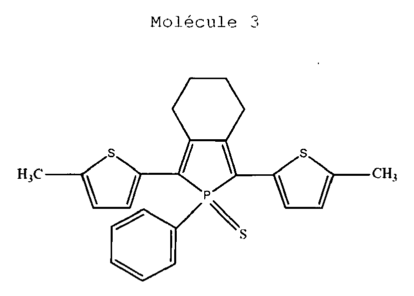

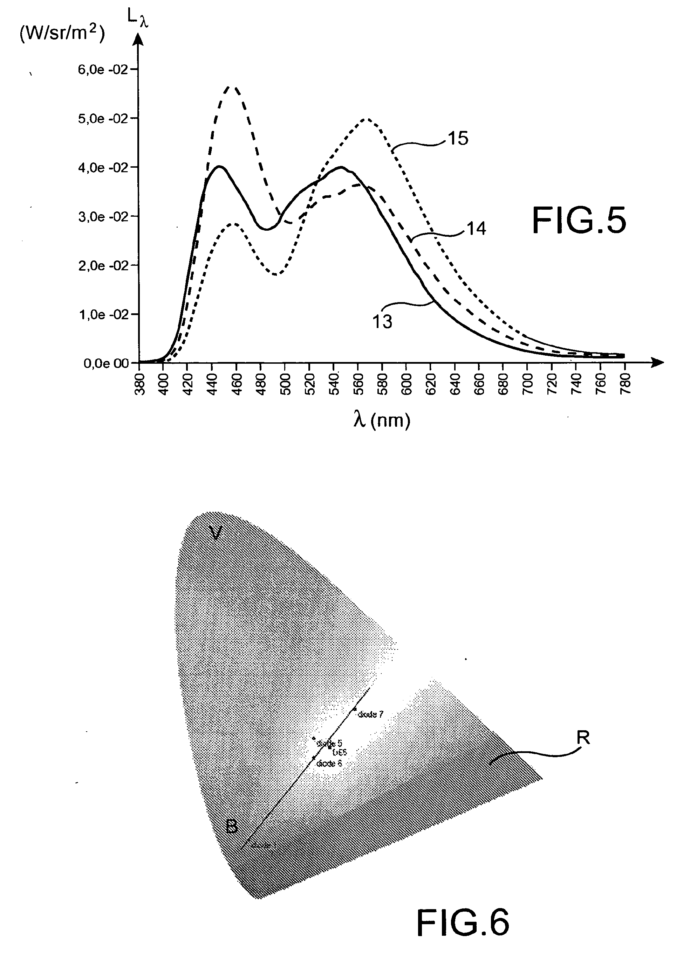

Cette substitution des cycles thiophènes de la molécule 3 par un groupement donneur faible méthyle permet d'obtenir un léger décalage vers le rouge de l'émission du dopant, comme le montrent les spectres d'électroluminescence des diodes 6 et 7, en comparaison de celui de la diode 5. La figure 5 représente les spectres d'électroluminescence des diodes 5 (courbe 13), 6 (courbe 14) et 7 (courbe 15).

De plus il en résulte des diodes ayant de très bonnes efficacités quantiques, de 3,6 à 3,9% pour des pourcentages en poids de dopage dans le NPB de 0,2% et 0,4% respectivement, comme le montre le tableau 3.

**Tableau 3**

| Diode | λₑₘ max (nm) | Efficacités | | | CIE | | Couleur |
|---|---|---|---|---|---|---|---|
| | | % | cd/A | Im/W | x | y | |
| 6/NPB: molécule 3 (0,20%) | 456/564 | 3,6 | 7,8 | 2,0 | 0,282 | 0,306 | blanc |
| 7/NPB: molécule 3 (0,40%) | 456/568 | 3,9 | 10,0 | 2,6 | 0,362 | 0,41 | blanc-jaune |

L'émission de la diode 6 est blanche. Quant à celle de la diode 7, elle est blanc-jaune comme le montrent leurs coordonnées chromatiques indiquées sur la figure 6.

Le décalage vers le rouge de l'émission de la molécule 3 par substitution de ses groupes thiophènes latéraux a ainsi permis d'obtenir des diodes blanches efficaces avec des coordonnées chromatiques plus proches de celles du D65, l'illuminant standard CIE de référence sous lumière du jour, et qui sont (0,313; 0,329).

Dans les exemples présentés ci-dessus, les dérivés du phosphole sont préférentiellement utilisés comme complément d'un émetteur bleu.

### REFERENCES

[1] « White Organic hight-Emitting Devices for Solid-State Lighting », B. W. D'Andrade et al., Adv. Mater. 2004, 16, No. 18, 1585-1595.
[2] « Blue and white emitting organic diodes based on anthracene derivative », Z. L. Zhang et al., Synthetic Metals 137 (2003), pages 1141-1142.
[3] « Highly-bright white organic light-emitting diodes based on a single emission layer », C. H. Chuen et al., Appl. Phys. Lett., Vol. 81, No. 24, 9 décembre 2002, pages 4499 à 4501.
[4] « First Examples of Organophosphorus-Containing Materials for Light-Emitting Diodes », C. Fave et al., J. Am. Chem. Soc., 2003, 125, pages 9254-9255.
[5] « Toward functional pi-conjugated organophosphorus materials : design of phosphole-based oligomers for electroluminescent devices », H. C. Su et al., J. Am. Chem.. Soc., 2006, 128(3), pages 983 à 995.
[6] « Synthesis and Properties of First Well-Defined Phosphole-Containing π-conjugated Polymers", Y. Morisaki et al., Macromolecules 2003, 36, 2594-2597.

## Revendications

1. Diode organique électroluminescente blanche, fournissant, sous l'effet d'une polarisation électrique, une lumière blanche composée du mélange d'au moins une première couleur et une deuxième couleur émises respectivement par un premier matériau luminophore et par un deuxième matériau luminophore, **caractérisée en ce que** l'un de ces matériaux luminophores est le matériau à base de phosphole suivant 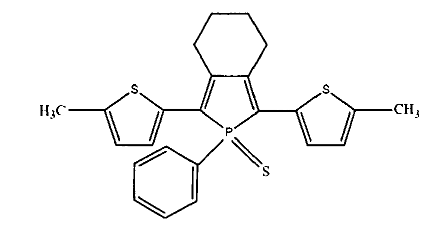 et est présent en tant que dopant d'une couche de transport de trous en NPB . (N,N'-bis-(1-naphthyl)-N,N'-diphényl-1,1'-biphényl-4,4'-diamine).

## Claims

1. White electroluminescent organic diode, providing, under the effect of an electrical polarization, a white light composed of a mixture of at least one first colour and a second colour emitted respectively by a first phosphorous material and by a second phosphorous material, **characterised in that** one of these phosphorous materials is the following phosphole-based material : 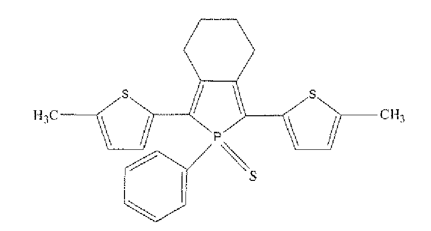 and is present as dopant of a hole transport layer made of NPB (N,N'-bis- (1-naphthyl)- N,N'- diphenyl-1,1'-biphenyl-4,4'-diamine).

## Patentansprüche

1. Weiße organische Elektrolumineszenz-Diode, welche unter der Wirkung einer Elektrischen Vorspannung ein weißes Licht liefert, das aus einem Gemisch wenigstens einer ersten und einer zweiten Farbe zusammengesetzt ist, die von einem ersten Luminophor-Material beziehungsweise einem zweiten Luminophor-Material emittiert werden, **dadurch gekennzeichnet, dass** eines der Luminophor-Materialien ein Material auf der Basis von Phosphol gemäß der Formel 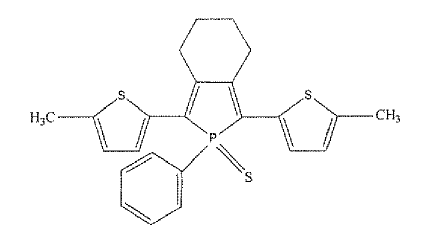 ist und als Dotierung einer Löcher-Transportschicht aus NPB (N,N'-bis-(1-naphthyl)- N,N'-diphenyl-1,1'-biphenyl- 4,4' diamin) verlegt.
